(19) Europäisches Patentamt / European Patent Office / Office européen des brevets

(11) EP 3 869 692 A1

(12) DEMANDE DE BREVET EUROPEEN

(43) Date de publication:
25.08.2021 Bulletin 2021/34

(51) Int Cl.:
H03L 1/02 (2006.01)     H04B 1/48 (2006.01)

(21) Numéro de dépôt: 21156696.3

(22) Date de dépôt: 11.02.2021

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 21.02.2020 FR 2001753

(71) Demandeurs:
• STMICROELECTRONICS (GRENOBLE 2) SAS
38000 Grenoble (FR)
• STMicroelectronics S.r.l.
20864 Agrate Brianza (MB) (IT)

(72) Inventeurs:
• MANGANO, Daniele
95027 San Gregorio di Catania (IT)
• MARCHAND, Benoit
38120 Fontanil-Cornillon (FR)
• LEOTTA, Santo
95024 Acireale (CT) (IT)
• QUERINO DE CARVALHO, Hamilton
38100 Grenoble (FR)

(74) Mandataire: Cabinet Beaumont
4, Place Robert Schuman
B.P. 1529
38025 Grenoble Cedex 1 (FR)

(54) COMPENSATION DE DÉRIVE DE FREQUENCE

(57) La présente description concerne un dispositif (60) comprenant : un circuit électronique (20) ; un circuit oscillant (12) comprenant un quartz (14), configuré pour fournir un signal d'horloge au circuit électronique (20) ; et un élément chauffant (62) configuré pour augmenter la température du quartz (14).

## Fig. 8

EP 3 869 692 A1

## Description

### Domaine technique

La présente description concerne de façon générale des dispositifs électroniques, en particulier des dispositifs électroniques comprenant un circuit oscillant.

### Technique antérieure

Les dispositifs électroniques comprennent souvent un circuit oscillant, afin de générer une fréquence centrale souhaitée.

On utilise souvent un cristal de quartz dans les circuits oscillants. En effet, une caractéristique des cristaux de quartz est qu'ils peuvent produire des oscillations relativement stables lorsqu'ils reçoivent une tension électrique.

### Résumé de l'invention

Un mode de réalisation pallie tout ou partie des inconvénients des dispositifs électroniques connus comprenant un cristal de quartz.

Un mode de réalisation prévoit un procédé de commande d'un dispositif comprenant un circuit oscillant, configuré pour fournir un signal d'horloge à un circuit radiofréquence, et une antenne, dans lequel l'activation du passage du signal du circuit vers l'antenne est retardée par rapport à un instant à partir duquel un amplificateur de puissance du circuit est activé.

Selon un mode de réalisation, l'activation du passage du signal du circuit vers l'antenne correspond au déplacement d'un commutateur à partir d'une première position vers une deuxième position, la première position étant configurée de telle sorte qu'aucune émission ne puisse être faite par l'intermédiaire de l'antenne, et la deuxième position étant configurée de telle sorte que les émissions puissent être faites par l'intermédiaire de l'antenne.

Selon un mode de réalisation, un seul signal de commande est généré pour activer l'amplificateur de puissance et le passage du signal du circuit vers l'antenne, le retard étant ajouté à l'unique signal de commande avant que le signal de commande atteigne un commutateur couplé entre le circuit et l'antenne, par rapport à l'instant où ce signal de commande atteint l'amplificateur.

Selon un mode de réalisation, la durée du retard est inférieure à une seconde.

Selon un mode de réalisation, la durée du retard est supérieure à 5 ms.

Selon un mode de réalisation, la durée du retard dépend de la température mesurée par un capteur de température du dispositif.

Selon un mode de réalisation, la température ou chaque température est indicative de la température ambiante.

Selon un mode de réalisation, le dispositif comprend une pluralité de valeurs de durée du retard stockées dans une mémoire, chaque valeur de durée correspondant à une plage de température.

Selon un mode de réalisation, les valeurs de durée associées à certaines des températures sont nulles.

Selon un mode de réalisation, les valeurs de durée associées à au moins l'une des températures sont différentes de zéro.

Selon un mode de réalisation, le circuit radiofréquence est un émetteur-récepteur radiofréquence.

Selon un mode de réalisation, le dispositif comprend, couplés en série, un premier condensateur variable, un premier condensateur, un cristal de quartz et un deuxième condensateur variable, comprenant un contrôle des capacités des premier et deuxième condensateurs variables pour qu'elles soient supérieures à 50 % de leur capacité maximum.

Selon un mode de réalisation, le procédé comprend les étapes suivantes : A) chauffer le quartz ; B) activer l'émission de signaux lorsque la température du quartz diminue.

Un autre mode de réalisation prévoit un dispositif comprenant : un circuit radiofréquence et une antenne ; un circuit oscillant configuré pour fournir un signal d'horloge au circuit RF ; et un circuit de commande configuré pour activer un amplificateur de puissance du circuit radiofréquence et pour activer le passage de signaux du circuit vers l'antenne, l'activation du passage du signal du circuit vers l'antenne étant retardée par rapport à un instant à partir duquel l'amplificateur de puissance est activé.

Selon un mode de réalisation, le dispositif comprend un capteur configuré pour mesurer une température ou une valeur représentative de la température.

Selon un mode de réalisation, le dispositif comprend une mémoire configurée pour stocker des valeurs de durée de retards correspondant à des plages de température.

Selon un mode de réalisation, le dispositif comprend, couplés en série, un premier condensateur variable, un premier condensateur, un cristal de quartz et un deuxième condensateur variable.

Selon un mode de réalisation, le dispositif comprend un élément chauffant configuré pour augmenter la température du quartz.

Un autre mode de réalisation prévoit un dispositif électronique comprenant un premier condensateur et un cristal de quartz couplés en série entre un premier nœud et un deuxième nœud ; un inverseur couplé entre les premier et deuxième nœuds ; un premier condensateur variable couplé entre le premier nœud et un troisième nœud ; et un deuxième condensateur variable couplé entre le deuxième nœud et le troisième nœud.

Selon un mode de réalisation, la valeur du premier condensateur est choisie, sur la base d'une fréquence cible, pour réduire la capacité équivalente vue par le quartz par rapport à une capacité résultant des deux condensateurs variables seulement.

Selon un mode de réalisation, le premier condensateur variable, le condensateur, le cristal de quartz et le deuxième condensateur variable sont inclus dans un circuit oscillant.

Selon un mode de réalisation, le circuit oscillant est configuré pour fournir un signal d'horloge à un circuit.

Selon un mode de réalisation, le circuit est un émetteur RF.

Selon un mode de réalisation, les condensateurs variables font partie d'un circuit intégré et le cristal de quartz et le condensateur ne font pas partie du circuit intégré.

Selon un mode de réalisation, la valeur de capacité du premier condensateur est constante.

Selon un mode de réalisation, le dispositif comprend un deuxième condensateur couplé entre le quartz et le deuxième condensateur variable.

Selon un mode de réalisation, le dispositif comprend:

un circuit radiofréquence et une antenne ; un circuit oscillant configuré pour fournir un signal d'horloge au circuit RF ; et un circuit de commande configuré pour activer un amplificateur de puissance du circuit radiofréquence et pour activer le passage de signaux du circuit vers l'antenne, l'activation du passage du signal du circuit vers l'antenne étant retardée par rapport à un instant à partir duquel l'amplificateur de puissance est activé.

Selon un mode de réalisation, le dispositif comprend un élément chauffant configuré pour augmenter la température du quartz.

Un autre mode de réalisation prévoit un procédé de commande du dispositif précédent, comprenant un contrôle des capacités des premier et deuxième condensateurs variables pour qu'elles soient supérieures à 50 % de leur capacité maximum.

Selon un mode de réalisation, le procédé comprend un contrôle des capacités des premier et deuxième condensateurs variables pour qu'elles soient sensiblement égales.

Selon un mode de réalisation, le procédé comprend un circuit oscillant, configuré pour fournir un signal d'horloge à un circuit radiofréquence, et une antenne, et l'activation du passage du signal du circuit vers l'antenne est retardée par rapport à un instant à partir duquel un amplificateur de puissance du circuit est activé.

Selon un mode de réalisation, le procédé comprend les étapes suivantes : A) chauffer le quartz ; B) activer l'émission de signaux lorsque la température du quartz diminue.

Un autre mode de réalisation prévoit un dispositif comprenant : un circuit électronique ; un circuit oscillant comprenant un quartz, configuré pour fournir un signal d'horloge au circuit électronique ; et un élément chauffant configuré pour augmenter la température du quartz.

Selon un mode de réalisation, le circuit électronique est un émetteur-récepteur radiofréquence et est couplé à une antenne.

Selon un mode de réalisation, le dispositif comprend un circuit de commande configuré pour contrôler l'élément chauffant.

Selon un mode de réalisation, l'élément chauffant est dédié au préchauffage du quartz.

Selon un mode de réalisation, l'élément chauffant est éloigné du quartz de moins de 10 mm.

Selon un mode de réalisation, l'élément chauffant est une résistance.

Selon un mode de réalisation, le dispositif comprend :

une antenne ; un circuit de commande configuré pour activer un amplificateur de puissance du circuit et pour activer le passage de signaux du circuit vers l'antenne, l'activation du passage du signal du circuit vers l'antenne étant retardée par rapport à un instant à partir duquel l'amplificateur de puissance est activé.

Selon un mode de réalisation, le dispositif comprend, couplés en série, un premier condensateur variable, un premier condensateur, le cristal de quartz et un deuxième condensateur variable.

Un autre mode de réalisation prévoit un procédé de commande du dispositif précédent, comprenant les étapes suivantes : A) chauffer le quartz ; B) activer l'émission de signaux lorsque la température du quartz diminue.

Selon un mode de réalisation, l'étape A) comprend l'augmentation d'un courant passant dans la résistance.

Selon un mode de réalisation, l'activation du passage du signal du circuit vers l'antenne est retardée par rapport à un instant à partir duquel un amplificateur de puissance du circuit est activé.

Selon un mode de réalisation, le procédé comprend un contrôle des capacités des premier et deuxième condensateurs variables pour qu'elles soient supérieures à 50 % de leur capacité maximum.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, très schématiquement, un exemple de dispositif électronique capable de transmettre des signaux RF ;

la figure 2 est un graphique représentant la dérive d'une fréquence du dispositif de la figure 1 par rapport à une fréquence centrale souhaitée en fonction du temps ;

la figure 3 est un graphique représentant la dérive d'une fréquence du dispositif de la figure 1 par rapport à une fréquence centrale souhaitée en fonction du temps et de deux signaux du dispositif de la figure 1 ;

la figure 4 est un graphique représentant la dérive d'une fréquence du dispositif de la figure 1 par rapport à une fréquence centrale souhaitée, en fonction du temps, pour plusieurs températures ambiantes ;

la figure 5 représente, schématiquement, un procédé pour contrôler le dispositif de la figure 1 ;

la figure 6 représente schématiquement un mode de réalisation d'un dispositif comprenant un circuit oscillant ;

la figure 7 est un graphique représentant la dérive de la fréquence du dispositif de la figure 6 en fonction de la valeur de capacité de condensateurs du circuit oscillant de la figure 6 ;

la figure 8 représente, très schématiquement, un exemple de dispositif électronique capable de transmettre des signaux RF ;

la figure 9 est un graphique représentant l'impact de variations de température sur un quartz pendant les premières 300 ms ;

la figure 10 est un graphique représentant un exemple de la dérive obtenue avec le mode de réalisation de la figure 8 ; et

la figure 11 représente un mode de réalisation d'un procédé de commande du dispositif de la figure 8.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments couplés entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

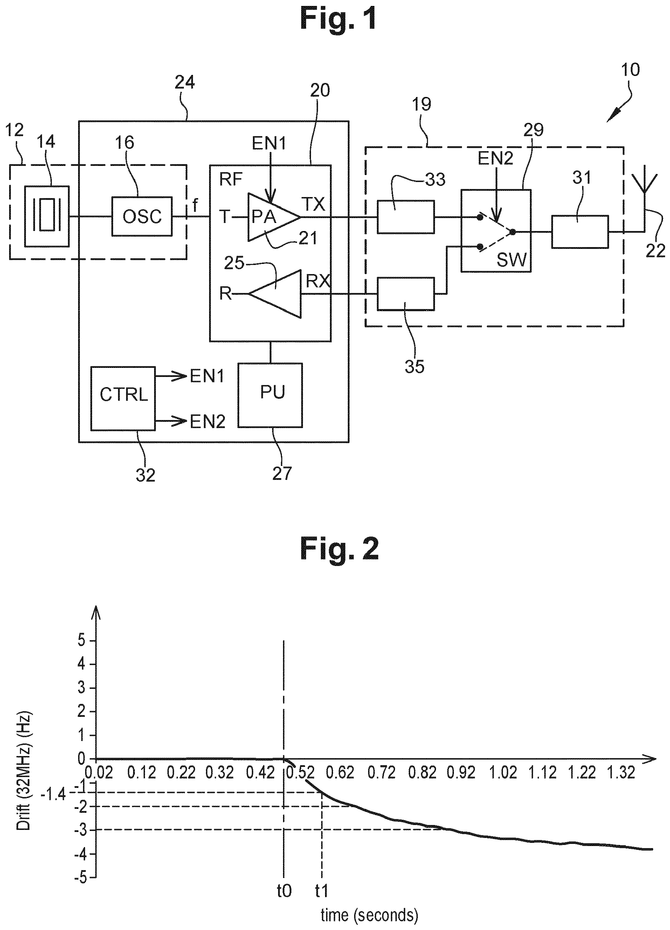

La figure 1 représente, très schématiquement, un exemple de dispositif électronique 10 pouvant transmettre des signaux RF. Par exemple, le dispositif 10 est adapté à des émissions à faible puissance et à longue distance. De préférence, le dispositif est adapté à fonctionner avec la technologie nommée LoRa (longue distance).

Le dispositif 10 comprend un circuit oscillant 12. Le circuit oscillant 12 comprend un cristal de quartz 14 et un oscillateur (OSC) 16. La sortie de l'oscillateur 16 est couplée, de préférence connectée, à un circuit émetteur-récepteur (RF) 20. Le circuit oscillant 16 fournit un signal d'horloge, ayant une fréquence centrale f, au circuit 20. La valeur souhaitée de la fréquence centrale f est par exemple égale à 32 MHz.

L'oscillateur 16 et le circuit émetteur-récepteur 20 sont intégrés dans un seul circuit ou une seule puce 24, tandis que le quartz 14 constitue un composant externe du circuit 24.

Le circuit 20 est couplé à une antenne 22. Le circuit 20 est par exemple un émetteur-récepteur RF. En d'autres termes, le circuit 20 est par exemple un émetteur-récepteur capable de transmettre (émettre et recevoir) des signaux à une fréquence radio (RF), en d'autres termes des signaux RF. Le circuit 20 peut émettre et recevoir des signaux radiofréquence. Le circuit 20 constitue une tête d'émission et/ou de réception couplée à l'antenne 22 par divers circuits frontaux analogiques 19 (réseaux d'adaptation, convertisseurs, commutateurs, symétriseurs, etc.). Les circuits frontaux sont externes à la puce 24.

Le circuit 20 comprend une sortie TX sur laquelle les signaux à émettre sont fournis. La sortie TX est fournie par un amplificateur de puissance 21 (PA) du circuit 20. L'amplificateur de puissance 21 comprend une entrée sur laquelle est fourni un signal T, représentatif d'un signal à émettre. L'amplificateur de puissance 21 comprend une entrée d'activation recevant un signal de commande EN1, ou signal d'activation EN1. Le signal EN1 est un signal configuré pour activer ou désactiver l'amplificateur de puissance 21. Le signal EN1 est par exemple un signal binaire. Une première valeur du signal EN1, par exemple la valeur haute '1', active l'amplificateur de puissance 21, et par conséquent permet la production en sortie du signal TX. Une deuxième valeur du signal EN1, par exemple la valeur basse '0', désactive l'amplificateur de puissance 21. Par conséquent, lorsque le signal EN1 prend la deuxième valeur, aucun signal ne peut être émis par le circuit 20.

Le circuit 20 comprend une entrée RX, sur laquelle peuvent être reçus des signaux provenant de l'antenne 22. Plus précisément, les signaux reçus par l'antenne 22 sont fournis à l'entrée RX par l'intermédiaire de circuits frontaux 19. L'entrée RX est par exemple couplée, de préférence connectée, à une entrée d'un amplificateur à faible bruit 25 du circuit 20. Une sortie de l'amplificateur à faible bruit fournit un signal R représentatif du signal RX reçu.

La puce 24 comprend une unité de traitement 27 (PU). L'unité de traitement 27 est couplée, de préférence connectée, au circuit 20. La sortie de l'amplificateur à faible bruit 25 et l'entrée de l'amplificateur de puissance 21 sont par exemple couplées à l'unité de traitement 27. L'unité de traitement 27 est configurée pour traiter les données à envoyer, et par conséquent le signal T, et pour traiter les données reçues, en d'autres termes le signal R. Les liaisons entre l'unité de traitement 27 et l'amplificateur de puissance 21 et entre l'unité de traitement 27 et l'amplificateur à faible bruit 25 ne sont pas détaillés en figure 1.

Le dispositif 10 de la figure 1 est un système semi-duplex. Par conséquent, le dispositif peut soit émettre soit recevoir des signaux, mais ne peut pas faire les deux simultanément. La sortie TX et l'entrée RX du circuit 20 sont couplées à l'antenne 22 par un commutateur 29 (SW). Le commutateur 29 est couplé, d'un côté, à la sortie TX et à l'entrée RX et, de l'autre côté, à l'antenne. Dans un premier état du commutateur 29, l'antenne est couplée à la sortie TX. Dans ce premier état, il est possible d'émettre des signaux par l'intermédiaire de l'antenne 22. Toutefois, il n'est pas possible de recevoir des signaux. Dans un deuxième état du commutateur 29, l'antenne est couplée à l'entrée RX. Dans ce deuxième état, il est possible de recevoir des signaux provenant de l'antenne 22. Toutefois, il n'est pas possible d'émettre des signaux.

Le commutateur 29 peut aussi comprendre un troisième état, non représenté, dans lequel l'antenne est couplée à un nœud de haute impédance.

Selon un mode de réalisation, le commutateur 29 reçoit un signal de commande EN2, ou signal d'activation EN2, différent du signal de commande EN1. Le signal de commande EN2 prend différentes valeurs en fonction de l'état souhaité du commutateur. Par exemple, une première valeur du signal EN2 assure que le commutateur 29 est dans le premier état et une deuxième valeur du signal EN2 assure que le commutateur 29 est dans le deuxième état. Si le commutateur peut être dans plus que deux états, le signal de commande EN2 peut prendre plus que deux valeurs.

Le commutateur 29 fait partie du circuit 19 et est couplé à l'antenne 22 et au circuit 24 respectivement par un bloc 31 et par des blocs 33 et 35.

Comme cela est illustré en figure 1, le bloc 31 couple le nœud commun du commutateur 29 à l'antenne 22, alors que les blocs 33 et 35 couplent respectivement les nœuds commutés du commutateur 29 aux circuits 21 et 25.

Le dispositif 10 comprend en outre un circuit de commande (CTRL) 32. Le circuit de commande 32 est configuré pour commander différents éléments du dispositif 10. En particulier, le circuit de commande 32 fournit les signaux de commande EN1 et EN2, respectivement au circuit 20 et au commutateur 29. Le circuit 32 est par exemple intégré dans la puce 24.

Lorsque l'amplificateur 21 est activé, la production en sortie de signaux est rendue possible sur la sortie TX. Toutefois, une fois que l'amplificateur de puissance est activé, sa température augmente notablement, ce qui provoque l'augmentation de la température du circuit 24. L'augmentation de la température du circuit 24 est au moins partiellement responsable d'une dérive de la fréquence du signal d'horloge fourni au circuit 20 par l'oscillateur 16. Cette dérive correspond à la différence entre la fréquence centrale effective du signal qui peut être utilisée par l'émetteur-récepteur 20 pour émettre un signal et la fréquence centrale souhaitée. La dérive peut aussi être au moins partiellement provoquée par l'échauffement du cristal de quartz. Une telle dérive est illustrée en figure 2.

La figure 2 est un graphique illustrant la dérive (Drift (32MHz) (Hz)) d'une fréquence du dispositif de la figure 1 par rapport à une fréquence centrale souhaitée en fonction du temps (time (seconds)). Le graphique de la figure 2 illustre l'impact de l'échauffement de l'amplificateur de puissance 21 du circuit 20. L'échauffement de l'amplificateur de puissance 21 provoque la dérive de la fréquence f fournie à l'émetteur-récepteur RF 20 par le circuit oscillant 12.

Les valeurs de la dérive sont calculées par rapport à une fréquence centrale souhaitée de 32 MHz. La dérive est par conséquent égale à la différence entre la valeur effective de la fréquence centrale et la valeur 32 MHz.

Avant un instant t0, l'amplificateur de puissance est désactivé et aucune émission ne peut être faite, par conséquent la température est sensiblement constante et il n'y a pas de dérive significative. La dérive est par conséquent sensiblement égale à zéro.

À l'instant t0, l'amplificateur de puissance 21, inclus dans le circuit RF 20, est activé. Par conséquent, la température de la puce 24 augmente et la fréquence f du signal d'horloge dérive par rapport à la fréquence centrale souhaitée.

Après l'instant t0, la valeur de la dérive diminue et devient négative. En d'autres termes, la valeur absolue de la dérive augmente.

La figure 2 représente la dérive pendant une période d'environ une seconde après l'activation de l'amplificateur de puissance 21. Pendant cette seconde initiale de fonctionnement, la dérive diminue et atteint une valeur sensiblement égale à -4 Hz. La valeur de la dérive atteint la valeur -1,4 Hz à un instant t1.

Il est particulièrement important pour des émetteurs-récepteurs RF, comme le circuit 20, que la fréquence du signal d'horloge soit aussi constante que possible pendant le fonctionnement (en particulier pendant l'émission ou la réception) de l'émetteur-récepteur (ou récepteur ou émetteur).

La dérive peut être particulièrement problématique pendant la période initiale d'émission. Dans certaines applications, par exemple dans le cas du réseau à grande distance LoRa (LoRaWAN)Cl, il est préférable, par exemple comme spécifié dans les normes, que la valeur absolue de la dérive, pendant la seconde initiale d'émission, soit inférieure à une valeur de seuil th de 40 Hz, pour une fréquence centrale souhaitée de 915 MHz. Toutefois, la dérive est proportionnelle à la fréquence centrale souhaitée. En conséquence, la valeur de seuil de 40 Hz pour une fréquence centrale souhaitée de 915 MHz correspond à une valeur de seuil de la dérive d'environ 1,4 Hz pour une fréquence centrale souhaitée de 32 MHz. Ce seuil est traversé à l'instant t1 de l'exemple de la figure 2.

Une valeur négative de la dérive signifie que la valeur réelle de la fréquence du signal d'horloge fourni à l'émetteur-récepteur RF 20 est inférieure à la valeur souhaitée. Une valeur de dérive positive signifie que la valeur réelle de la fréquence est supérieure à la valeur souhaitée. Une valeur de dérive égale à zéro signifie que la valeur réelle de la fréquence du signal d'horloge fourni à l'émetteur-récepteur RF est égale à la valeur souhaitée.

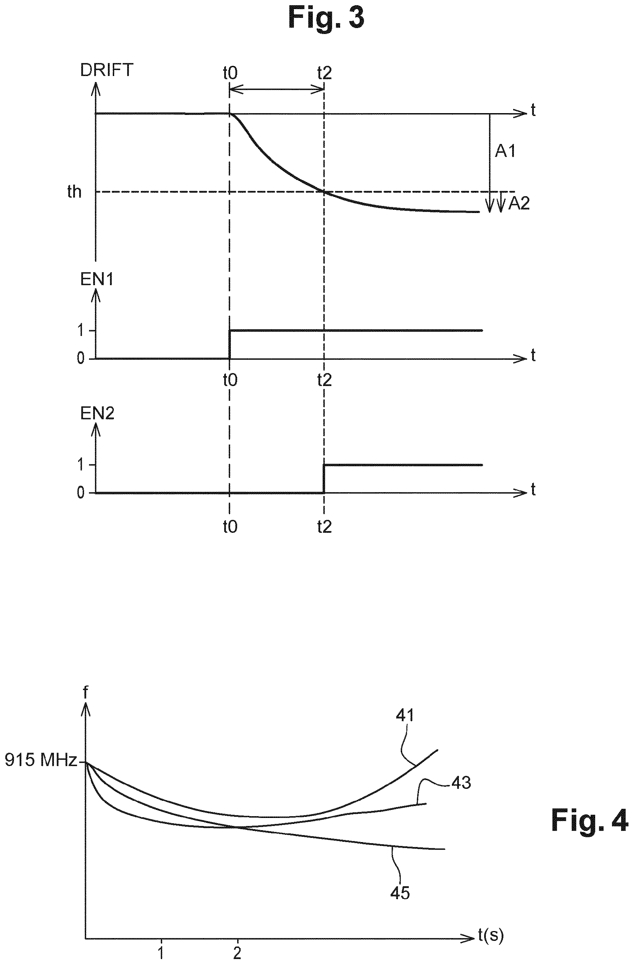

Selon un mode de réalisation, le circuit de commande est configuré pour garantir un délai entre l'activation de l'amplificateur de puissance 21 et l'activation du passage du signal à envoyer à l'antenne à partir de la sortie TX. Par exemple, l'activation du passage du signal correspond à mettre le commutateur 29 dans l'état permettant le passage de signaux à émettre et pas le passage de signaux à recevoir. En d'autres termes, le signal de commande EN2 du commutateur 29 est mis à la première valeur '1' après l'activation de l'amplificateur de puissance 21. Par conséquent, les signaux EN1 et EN2 ne prennent pas leur première valeur au même instant. Le signal de commande EN1 prend sa première valeur, et après un retard, le signal de commande EN2 prend sa première valeur. On va décrire un tel procédé de commande du dispositif 10 plus en détail en relation avec la figure 3.

La figure 3 est un graphique illustrant la dérive (DRIFT) de la fréquence f du dispositif de la figure 1 par rapport à une fréquence centrale souhaitée en fonction du temps (t) et des deux signaux d'activation respectifs (EN1, EN2) de l'amplificateur 21 et du commutateur 29 du dispositif de la figure 1.

Les valeurs de la dérive sont calculées par rapport à une fréquence centrale souhaitée de 32 MHz. La dérive est par conséquent égale à la différence entre la valeur effective de la fréquence centrale et la valeur de 32 MHz.

Avant un instant t0, les signaux de commande EN1 et EN2 ont la deuxième valeur. En d'autres termes, avant l'instant t0, l'amplificateur de puissance 21 est désactivé et le commutateur 29 est configuré pour permettre la réception de signaux mais pas l'émission. Comme l'amplificateur de puissance est désactivé, il ne produit pas de chaleur et la dérive est sensiblement égale à zéro.

Plus généralement, avant l'instant t0, le commutateur 29 peut être dans un état quelconque. En effet, comme l'amplificateur de puissance est désactivé, aucun signal ne va être envoyé par l'intermédiaire de la sortie TX, quel que soit l'état du commutateur 29.

À l'instant t0, l'amplificateur de puissance 21 de la figure 1 est activé. En d'autres termes, le signal de commande généré par le circuit de commande 32 passe de la deuxième valeur ('0') à la première valeur ('1'). En outre, le passage du signal de la sortie TX vers l'antenne est bloqué. Dans l'exemple de la figure 2, le signal de commande EN2 conserve la deuxième valeur '0' correspondant à un état de réception. Toutefois, le commutateur peut être dans tout état qui ne permet pas le passage d'un signal à envoyer à partir de la sortie TX vers l'antenne.

Comme la température de l'amplificateur de puissance augmente, la dérive diminue. En d'autres termes, la valeur absolue de la dérive augmente. Cependant, puisque le signal EN2 a la deuxième valeur, il n'y a pas d'émission.

À un instant t2, ultérieur à l'instant t0 et séparé de l'instant t0 par un retard D, le signal de commande EN2 prend la première valeur. Par conséquent, à l'instant t2, des signaux à émettre peuvent atteindre l'antenne pour être envoyés vers un dispositif récepteur.

À l'instant t2, l'émission commence et le dispositif récepteur commence à recevoir le signal émis. La dérive du signal émis est la dérive A2, correspondant à la différence entre la fréquence effective du signal émis et la valeur de la fréquence au début de l'émission.

Le retard D est choisi de manière à assurer que la dérive A2 est en dessous du seuil th décrit précédemment. En outre, le retard D est de préférence choisi le plus petit possible, tout en respectant le seuil th.

Par exemple, le retard D est préprogrammé dans le dispositif, par exemple dans une mémoire.

Selon un autre mode de réalisation, un seul signal d'activation est généré par le circuit de commande 32, mais est retardé avant d'atteindre le commutateur 29. Par exemple, le dispositif 10 comprend un composant configuré pour ajouter un retard égal à D à l'unique signal de commande avant que le signal de commande atteigne le commutateur 29, par rapport à l'instant où l'amplificateur 21 est atteint par ce signal de commande.

On pourrait penser à utiliser un cristal de quartz compensé en température (TCXO - de l'anglais Temperature Controlled Crystal Oscillator) afin de compenser la dérive provoquée par l'activation de l'amplificateur de puissance. Toutefois, le coût d'un tel quartz sera considéré comme trop élevé dans de nombreuses applications.

Le dispositif 10 est de préférence configuré pour fonctionner avec la technologie LoRa. Dans un tel cas, il est souhaitable d'utiliser une puce standard 24, dont le matériel ne peut pas être modifié. Toute modification ou amélioration doit impliquer la programmation des composants de la puce 24 et/ou de composants externes à la puce 24, mais aucune modification des composants de la puce 24.

La figure 4 est un graphique illustrant la fréquence f du signal d'horloge du dispositif de la figure 1 en fonction du temps (t(s)) pour plusieurs températures ambiantes.

La figure 4 comprend trois courbes 41, 43, 45, chacune représentant la fréquence f pour une température ambiante différente. La courbe 41 correspond à une température ambiante de -40 °C. La courbe 43 correspond à une température ambiante de 80 °C. La courbe 45 correspond à une température ambiante de 25 °C.

Comme on peut le voir, en fonction de la température, la dérive présente différents comportements, en fonction de la température ambiante. Par exemple, la courbe 41 correspondant à une température de 85 °C présente des variations plus importantes que les autres courbes.

La valeur de l'instant t1 peut être différente pour chaque valeur de la température ambiante. Pour certaines valeurs de la température, l'instant t1 peut être égal à l'instant t0. Le retard peut par conséquent être égal à zéro pour certaine températures, mais pas pour toutes les températures. En effet, pour certaines températures, la valeur absolue de la dérive demeure en dessous du seuil t pendant la première seconde après l'instant t1.

Selon un mode de réalisation, le dispositif 10 est programmé avec une seule valeur du retard D. Cette valeur est de préférence choisie conformément au pire cas des instants t1 correspondant aux températures auxquelles le dispositif est supposé fonctionner.

Selon un mode de réalisation préféré, le retard D entre l'activation de l'amplificateur de puissance 21 et l'activation du commutateur 29 est sélectionné sur la base de la valeur de température mesurée par un capteur de température (SENSOR). Le capteur est intégré dans la puce 24. La température mesurée par le capteur est par exemple la température au niveau de la surface externe du dispositif, et ainsi par exemple indique la température ambiante autour du dispositif. En variante, la température mesurée par le capteur est la température à l'intérieur du dispositif 10, par exemple la température sur la puce 24.

Plusieurs valeurs du retard D peuvent être programmées dans le dispositif 10. Par exemple, chaque valeur du retard D peut être associée à une plage de températures ambiantes.

Les différents instants t1 et les plages de température correspondantes, qui sont par exemple programmées dans une mémoire du dispositif, sont de préférence générés au moment de la fabrication ou pendant un processus d'étalonnage. Par exemple, les variations de la dérive sont déterminées pour une pluralité de températures, chacune de la pluralité de températures correspondant à une plage de température. Cette étape est soit réalisée sur chaque dispositif soit sur un dispositif représentatif d'un lot de dispositifs. En variante, ce processus d'étalonnage peut ne pas être mis en œuvre. Les différents instants t1 et les plages de température correspondantes, sont par exemple des valeurs prédéfinies.

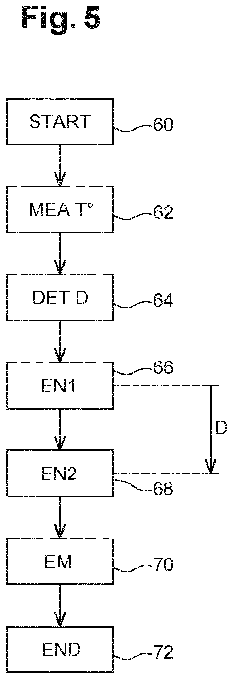

La figure 5 représente, schématiquement, un procédé de commande du dispositif de la figure 1. De préférence, les étapes du procédé sont successives. Le procédé est par exemple mis en œuvre par du matériel ou du logiciel. Le procédé est par exemple mis en œuvre par un moteur d'états.

Le procédé décrit en relation avec la figure 5 est par exemple exécuté au début (bloc 60, START) de l'émission de chaque signal émis, ou au début de l'émission de chaque groupe de signaux.

Pendant une première étape du procédé, le capteur de température mesure la température (bloc 62, MEA T°). Cette température est ensuite comparée aux valeurs ou à la plage de valeurs programmées dans le dispositif 10, et la valeur du retard D est déterminée (bloc 64, DET D) en fonction de cette valeur ou plage de température.

Pendant une étape suivante, le circuit de commande assure que l'amplificateur de puissance est activé (bloc 66, EN1), pendant que le passage de signaux de la sortie TX vers l'antenne est désactivé. Par exemple, le circuit de commande assure que le signal EN1 prend la première valeur ('1'), pendant que le signal EN2 a la deuxième valeur ('0'). Pendant que le signal EN1 a la première valeur et le signal EN2 a la deuxième valeur, un signal fictif T est par exemple appliqué sur l'entrée de l'amplificateur de puissance 21.

Le retard D commence au moment de l'activation de l'amplificateur de puissance. Par exemple, un compteur commence à compter au moment de l'activation de l'amplificateur de puissance. Lorsque la valeur du retard D est atteinte, le passage des signaux à émettre est autorisé (bloc 68, EN2). Par exemple, lorsque le compteur atteint la valeur D, le signal de commande EN2 prend la première valeur '1', alors que le signal de commande EN1 conserve la première valeur. Une ou plusieurs émissions peuvent être faites (bloc 70, EM).

Une fois qu'un ou plusieurs signaux ont été émis (bloc 72, END) l'amplificateur de puissance peut être désactivé et le passage de signaux de la sortie TX vers l'antenne peut être bloqué, par exemple en mettant la valeur du signal de commande EN2 à la deuxième valeur.

Un avantage du mode de réalisation décrit en relation avec les figures 1 à 5 est que la dérive vue par le dispositif récepteur est réduite.

Un autre avantage du mode de réalisation décrit en relation avec les figures 1 à 5 est qu'il peut être mis en œuvre sans modifications structurelles du circuit 24.

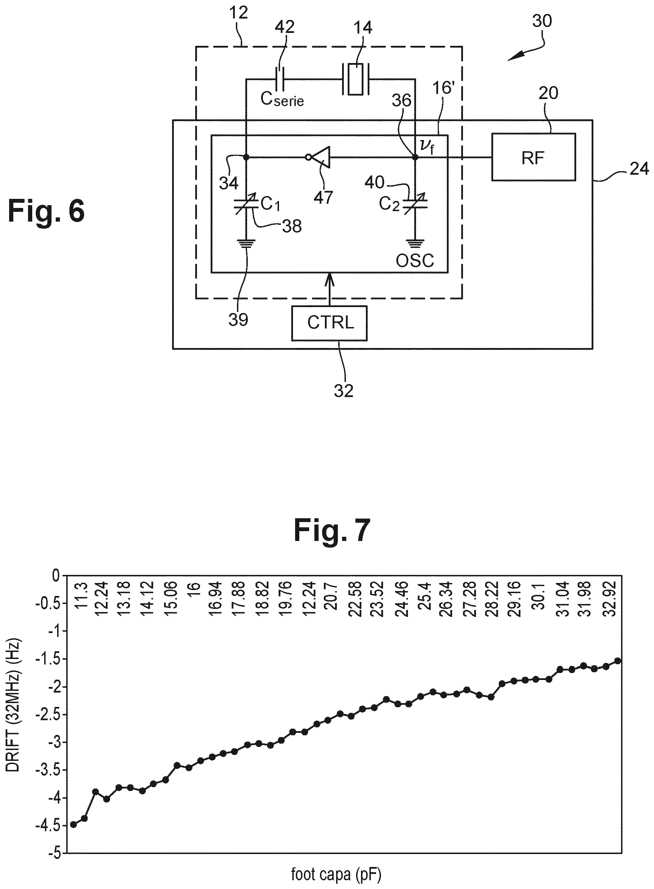

On va maintenant décrire un autre aspect de la présente description en relation avec les figures 6 à 8.

La figure 6 illustre schématiquement un mode de réalisation d'un dispositif 30 comprenant un circuit oscillant. Bien que certains des éléments puissent ne pas être représentés, le dispositif 30 comprend de préférence tous les éléments ayant déjà été décrits en relation avec la figure 1. Ils ne seront pas décrits de nouveau en détail. En particulier, le dispositif 30 comprend le cristal de quartz 14 et le circuit intégré 24, comprenant l'émetteur-récepteur RF 20. Le dispositif 30 peut aussi comprendre, entre autres, l'antenne 22, le circuit frontal 19 et le module de traitement 27, non représentés en figure 6.

Le circuit oscillant 12 fournit un signal d'horloge ($v_f$), ayant la fréquence f, à l'émetteur-récepteur 20. Le circuit oscillant 12 est par exemple un oscillateur de Pierce.

Le circuit oscillant 12 comprend un oscillateur 16'. L'oscillateur 16 comprend un inverseur 47. Une borne de sortie de l'inverseur 47 est couplée, de préférence connectée, à un premier nœud 34. Une borne d'entrée de l'inverseur est couplée, de préférence connectée, à un deuxième nœud 36. Le deuxième nœud 36 constitue le nœud de sortie de l'oscillateur. Le deuxième nœud 36 est couplé, de préférence connecté, à une borne d'entrée de l'émetteur-récepteur 20. Le signal d'horloge $v_f$ est fourni au niveau du deuxième nœud 36.

Le premier nœud 34 est couplé, de préférence connecté, à une borne d'un condensateur variable ($C_1$) 38. L'autre borne du condensateur 38 est couplée, de préférence connectée, à un nœud de référence 39, ou un nœud d'application d'une tension de référence, recevant une tension de référence. De préférence, le nœud de référence 39 est la masse.

Le deuxième nœud 36 est couplé, de préférence connecté, à une borne d'un condensateur variable ($C_2$) 40. L'autre borne du condensateur 40 est couplée, de préférence connectée, au nœud de référence 39 recevant la tension de référence.

Le condensateur variable 38, l'inverseur 47 et le condensateur variable 40 sont couplés, de préférence connectés, entre eux en série dans cet ordre.

Les condensateurs 38 et 40 sont des condensateurs de pied. Les condensateurs 38 et 40 sont utilisés pour modifier la capacité vue par le cristal de quartz 14 pendant une phase d'étalonnage de l'ensemble afin de compenser la dispersion de fabrication du quartz 14. Les condensateurs 38 et 40 sont, de préférence, identiques entre eux (excepté pour ce qui résulte de tolérances de fabrication).

Le circuit de commande 32 est configuré pour contrôler les condensateurs variables 38 et 40.

Comme cela sera montré plus en détail en relation avec la figure 7, une augmentation des valeurs de capacité des condensateurs variables 38 et 40 provoque, avantageusement, une réduction de la valeur absolue de la dérive de la fréquence du signal d'horloge fourni au circuit 20. Toutefois, augmentation de la valeur de capacité des condensateurs 38 et 40 impacte aussi la valeur de la capacité vue par le quartz, et par conséquent impacte la valeur de la fréquence centrale f du signal d'horloge.

Afin de compenser la modification de la valeur de capacité vue par le quartz, un condensateur 42 ($C_{SERIE}$) est couplé, de préférence connecté, en série avec le cristal de quartz 14. Le condensateur 42 permet l'utilisation de valeurs de capacité plus grandes pour les condensateurs 38 et 40 tout en maintenant la valeur de la capacité vue par le quartz sensiblement égale à une capacité cible $C_L$.

Le cristal de quartz 14 et le condensateur 42 sont couplés, en série, entre le premier nœud 34 et le deuxième nœud 36. Une borne du cristal de quartz 14 est couplée, de préférence connectée, à une borne du condensateur 42. L'autre borne du cristal de quartz est par exemple couplée, de préférence connectée, au deuxième nœud 36. L'autre borne du condensateur 42 est par exemple couplée, de préférence connectée, au premier nœud 34. En conséquence, le condensateur variable 38, le condensateur 42, le cristal de quartz 14 et le condensateur variable 40 sont couplés, de préférence connectés, en série, dans cet ordre. L'inverseur est couplé, de préférence connecté, en parallèle avec l'ensemble constitué du quartz 14 et du condensateur 42.

En variante, le condensateur variable 38, le cristal de quartz 14, le condensateur 42 et le condensateur variable 40 peuvent être couplés, de préférence connectés, entre eux en série, dans cet ordre.

En variante, le condensateur 42 peut être remplacé par deux condensateurs situés de chaque côté du quartz 14, l'un se trouvant entre le quartz et le nœud 34, et l'autre se trouvant entre le quartz et le nœud 36. Les valeurs des deux condensateurs sont par exemple choisies de manière à être, ensemble, équivalentes à la valeur du condensateur 42.

Le condensateur 42 est de préférence un condensateur ayant une valeur de capacité constante $C_{SERIE}$. Le condensateur n'est de préférence pas un condensateur variable. En d'autres termes, la valeur du condensateur 42 n'est de préférence pas contrôlée par le circuit de commande 32. La valeur du premier condensateur 42 est de préférence choisie, sur la base d'une fréquence cible, de manière à réduire la capacité équivalente vue par le quartz par rapport à une capacité résultant des deux condensateurs variables seulement.

De préférence, les condensateurs 38 et 40 sont contrôlés de telle manière que leurs capacités soient sensiblement égales. La capacité cible $C_L$ vue par le cristal de quartz 14 est, dans cet exemple, égale à :

[Math 1]

$$C_L = \frac{C_1 * C_2 * C_{SERIE}}{C_{SERIE} * (C_1 + C_2) + C_1 * C_2} + C_{STRAY}$$

où $C_1$ est la valeur de capacité du condensateur 38, $C_2$ est la valeur de capacité du condensateur 40, $C_{SERIE}$ est la valeur de capacité du condensateur 42, et $C_{STRAY}$ est la valeur de capacité vagabonde, ou parasite.

La capacité $C_{SERIE}$ du condensateur 42 est, en conséquence, égale à :

[Math 2]

$$C_{SERIE} = \frac{C_B*(C_L-C_{STRAY})}{C_B-2*(C_{STRAY}+C_L)}$$

où $C_L$ est la valeur cible de la capacité vue par le cristal de quartz, et $C_B$ est égale à la valeur $C_1$ et aussi égale à la valeur $C_2$ ($C_B = C_1 = C_2$).

Par exemple, si la valeur cible est sensiblement égale à 10 pF, si les capacités $C_1$ et $C_2$ sont toutes deux égales à 27 pF, et la capacité $C_{STRAY}$ est égale à 5 pF, la capacité $C_{SERIE}$ est égale à 60 pF. Plus généralement, les capacités $C_1$, $C_2$ et $C_{SERIE}$ sont choisies de manière à obtenir une capacité $C_L$ comprise entre 8 pF et 15 pF.

Puisque la puce 24 ne peut pas en général être modifiée afin de fonctionner avec la technologie LoRa, le condensateur 42 n'est par exemple pas situé dans la puce 24, mais à l'extérieur de la puce 24 (externe à la puce 24). Dans certains autres modes de réalisation, le condensateur 42 peut par exemple être situé dans la puce 24.

La figure 7 est un graphique illustrant la dérive (DRIFT (32MHz) (Hz)) de la fréquence du dispositif de la figure 6 en fonction de la valeur de capacité des condensateurs de pied (foot capa (pf)) du circuit oscillant 16.

Les valeurs de dérive sont en hertz (Hz) et les valeurs de capacité $C_1$ et $C_2$ sont en picofarads (pF). Les valeurs de dérive sont prises sensiblement 700 ms après l'activation de l'amplificateur de puissance du circuit 24 (l'instant t0 de la figure 2). Dans cet exemple, les instants t0 et t2 de la figure 3 sont identiques. Les valeurs sont donc prises pendant la première seconde après l'activation de l'amplificateur de puissance et le début de l'émission.

La figure 7 illustre des valeurs obtenues de manière empirique, par simulation ou expérimentation. Dans les simulations ou expérimentations correspondantes, les valeurs de capacité correspondent aux valeurs possibles des condensateurs variables 38 et 40. En d'autres termes, les valeurs de capacité de la figure 7 correspondent à la plage de valeurs possibles des condensateurs variables 38 et 40. On a considéré que les valeurs des deux condensateurs variables sont égales. Les valeurs de capacité sont comprises entre 11,3 pF et 32,92 pF.

Les valeurs de dérive sont comprises entre -4,5 Hz, pour des valeurs de capacités $C_1$ et $C_2$ sensiblement égales à 11 pF, et -1,5 Hz, pour des valeurs de capacités $C_1$ et $C_2$ sensiblement égales à 33 pF.

Les valeurs dépendent des conditions expérimentales. Néanmoins, il est possible d'observer une tendance générale dans laquelle la dérive diminue en valeur absolue lorsque la valeur de capacité augmente. En d'autres termes, la dérive tend vers zéro lorsque les valeurs de capacité des condensateurs 38 et 40 augmentent.

Par conséquent, comme cela a été indiqué précédemment, une augmentation des valeurs de capacité des condensateurs 38 et 40 présentent l'avantage de réduire la valeur absolue de la dérive. Il est par conséquent utile que les valeurs de capacité des condensateurs 38 et 40 soient aussi élevées que possible dans la plage de valeurs des condensateurs variables 38 et 40. Toutefois, afin de conserver la possibilité d'ajuster légèrement les valeurs de capacité des condensateurs 38 et 40 pendant le fonctionnement du circuit oscillant 12, il est préférable de choisir des valeurs de capacité des condensateurs 38 et 40 en dessous de leur valeur maximum, par exemple avec une marge sensiblement égale à 3 pF.

De préférence, les condensateurs 38 et 40 sont contrôlés de telle sorte que, au moins pendant la première seconde après le démarrage de l'oscillateur, les valeurs $C_1$ et $C_2$ soient égales à au moins 50 % de leur valeur maximum, de préférence strictement au-dessus de 50 % de leur valeur maximum, de préférence entre 60 et 85 % de leur valeur maximum, et par exemple sensiblement égales à 75 % de leur valeur maximum. La valeur de capacité $C_{SERIE}$ est choisie de manière à correspondre, comme cela a été décrit précédemment, à des condensateurs 38 et 40 ayant une valeur comprise entre 60 et 85 % de leur valeur maximum.

Un avantage des modes de réalisation décrits et que la dérive par rapport à la fréquence souhaitée est diminuée. La dérive peut être diminuée suffisamment pour satisfaire les exigences des dispositifs.

Un autre avantage des modes de réalisation décrits est que relativement peu de composants sont ajoutés au dispositif.

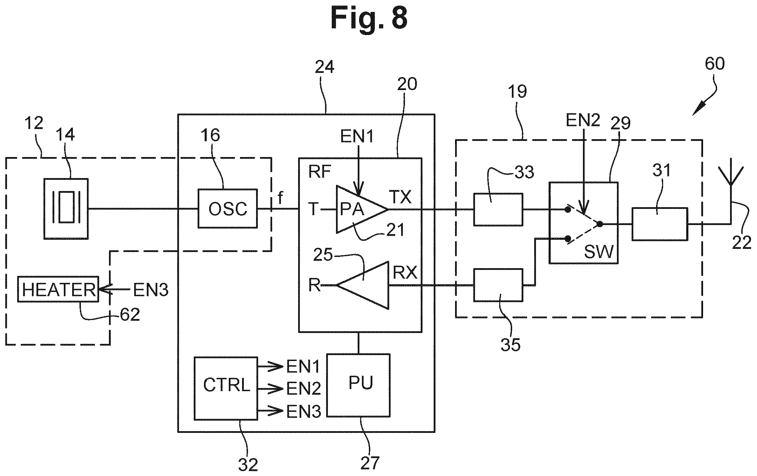

On va décrire un autre aspect de la présente description en relation avec les figures 8 à 12.

La figure 8 illustre, très schématiquement, un exemple de dispositif électronique 60 pouvant transmettre des signaux RF. Le dispositif 60 comprend tous les éléments du dispositif 10 de la figure 1. Par conséquent, le dispositif 60 comprend le quartz 14, l'antenne 22, les circuits frontaux 19 et la puce 24. La puce 24 comprend l'oscillateur 16, le circuit RF 20, le module de traitement 27 et le circuit de commande 32.

Le dispositif 60 comprend en outre un élément chauffant 62 (HEATER). L'élément chauffant est un composant électrique dissipant de la chaleur. L'élément chauffant 62 est par exemple un élément résistif. L'élément chauffant 62 est par exemple dans le circuit 12 et n'est pas dans le circuit intégré 24.

L'élément chauffant 62 est situé suffisamment proche du quartz 14 pour que la variation de température autour de l'élément chauffant puisse impacter le quartz. De préférence, l'élément chauffant est le plus près possible du quartz. Par exemple, l'élément chauffant est situé sur le quartz. Par exemple, l'élément chauffant peut être adjacent au quartz. Par exemple, la distance entre l'élément chauffant 62 et le quartz 14 est inférieure à 10 mm, de préférence inférieure à 5 mm, de préférence inférieure à 2 mm. De préférence, la distance entre l'élément chauffant 62 et le quartz 14 est inférieure à 1 mm. Par exemple, la distance entre l'élément chauffant 62 et le quartz 14 est sensiblement égale à 1 mm. Par exemple, l'élément chauffant est en contact avec le quartz.

L'élément chauffant est de préférence utilisé seulement pour le chauffage du quartz. De préférence, l'élément chauffant est dédié à la fonction de chauffage du quartz 14.

L'élément chauffant est par exemple une résistance. Par exemple, la valeur de la résistance est comprise entre 50 ohms et 150 ohms, par exemple égale à sensiblement 75 ohms.

L'élément chauffant fait par exemple partie d'un circuit électronique comprenant aussi des composants configurés pour contrôler l'élément chauffant 62. Par exemple, si l'élément chauffant est une résistance, la résistance fait partie d'un circuit configuré pour envoyer un courant dans la résistance afin d'augmenter la chaleur dissipée par la résistance.

Le circuit de commande 32 génère un signal de commande de EN3, ou signal d'activation EN3. Le signal de commande EN3 détermine l'état de l'élément chauffant, et en particulier si l'élément chauffant produit de la chaleur ou non. Par exemple, si l'élément chauffant est une résistance, le circuit de commande 28 contrôle le courant passant dans la résistance. Par exemple, le signal EN3 peut prendre au moins deux valeurs, une première valeur qui assure qu'un courant donné peut passer dans la résistance, et une deuxième valeur qui assure qu'aucun courant ne peut passer dans la résistance. Dans ce cas, lorsque le signal de commande EN3 prend la première valeur, la température de l'élément chauffant, et par conséquent la température du quartz, augmente jusqu'à atteindre une nouvelle température. Lorsque le signal de commande EN3 prend la deuxième valeur, la température de l'élément chauffant, et par conséquent la température du quartz, diminue, par exemple jusqu'à ce que l'élément chauffant atteigne la température qu'il avait avant que le signal de commande EN3 ne prenne la première valeur.

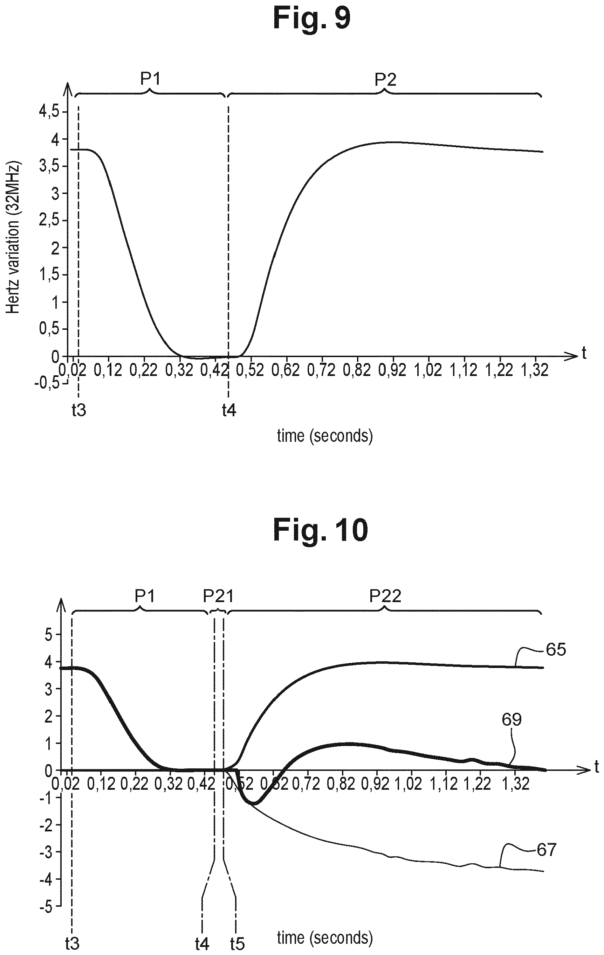

La figure 9 est un graphique illustrant l'impact de variations de température sur un quartz. En particulier, la figure 9 illustre un exemple de variations de la dérive (Hertz variation (32MHz)) de la fréquence, ou la variation de fréquence du signal d'horloge fourni par le circuit oscillant au circuit 20 de la figure 8, autour d'une fréquence porteuse en fonction du temps (time (seconds)).

Les valeurs de la dérive correspondent à une fréquence porteuse souhaitée de 32 MHz. Les valeurs de la dérive sont exprimées en hertz. Les valeurs du temps sont exprimées en secondes.

Les variations représentées en figure 9 sont indépendantes des variations de température provoquées par l'amplificateur de puissance 21. Par exemple, les variations représentées en figure 9 correspondent à une situation où l'amplificateur de puissance 21 est désactivé, et n'a pas d'impact sur la température.

On a considéré, pendant la période de temps considérée dans le graphique, que le quartz et l'oscillateur ont été en marche suffisamment longtemps pour être dans un état stable. Par conséquent, les variations décrites ci-après sont seulement provoquées par la variation de température de l'élément chauffant 62.

À un instant t3, l'élément chauffant 62 commence à chauffer et une première phase P1 commence. Plus précisément, le circuit de commande 32 contrôle l'élément chauffant 62 de manière à augmenter la température de l'élément chauffant. Par exemple, le signal de commande EN3 généré par le circuit de commande 32 prend la première valeur. Par exemple, le circuit de commande 32 augmente le courant passant dans l'élément chauffant.

Après l'instant t3, pendant la première phase P1, la température de l'élément chauffant augmente. Par exemple, la température augmente jusqu'à un seuil et arrête d'augmenter. La température de l'élément chauffant n'est pas réduite volontairement pendant la première phase P1.

On observe une diminution de la valeur de la dérive en conséquence de l'augmentation de la température. La valeur absolue de la dérive est réduite.

Dans l'exemple de la figure 9, la diminution de la fréquence est d'approximativement 3,8 Hz pendant la première phase, approximativement 0,30 secondes après l'instant t3.

À un instant t4, la première phase P1 se termine, et une deuxième phase P2 commence. Le circuit de commande 32 arrête de chauffer l'élément chauffant. Par exemple, le signal de commande EN3 généré par le circuit de commande 32 prend la première valeur. Par exemple, le circuit de commande 32 diminue, de préférence arrête, le courant passant dans la résistance. La température de l'élément chauffant, et celle du quartz, diminuent par conséquent pendant la deuxième phase.

Par exemple, la température diminue jusqu'à atteindre la température de l'instant t3.

On observe une augmentation de la valeur de la dérive pendant la deuxième phase P2. La valeur de la dérive s'éloigne de zéro avec le temps qui passe dans la deuxième phase P2. La valeur absolue de la dérive augmente.

Dans l'exemple de la figure 9, la dérive atteint une valeur sensiblement égale à 3,8 Hz, après approximativement 0,30 secondes.

L'augmentation de température dans la première phase P1 provoque une diminution de la dérive, et par conséquent une diminution de la valeur absolue de la dérive. La diminution de température dans la deuxième phase P2 provoque une augmentation de la dérive, et par conséquent une augmentation de la valeur absolue de la dérive.

Les variations de la dérive sont l'inverse des variations de la température. Le mode de réalisation décrit en relation avec les figures 8 à 11 tire avantage de cette caractéristique afin de compenser la dérive provoquée par l'amplificateur de puissance 21.

La figure 10 est un graphique illustrant un exemple de la dérive obtenue avec le mode de réalisation de la figure 8.

En particulier, la figure 10 représente un exemple de variations de la dérive (Hertz variation (32MHz)) de la fréquence, ou de la variation de fréquence, du signal d'horloge fourni par le circuit oscillant au circuit 20 de la figure 8, autour d'une fréquence porteuse en fonction du temps (time (seconds)).

Les valeurs de la dérive correspondent à une fréquence porteuse souhaitée de 32 MHz. Les valeurs de la dérive sont exprimées en hertz. Les valeurs du temps sont exprimées en secondes.

La figure 10 représente trois courbes. Une première courbe 65 est identique à la courbe de la figure 8 et représente l'impact de la variation de la température de l'élément chauffant sur la dérive de la fréquence porteuse du signal d'horloge fourni au circuit 20. Une deuxième courbe 67 est identique à la courbe de la figure 2 et correspond à l'impact du chauffage du circuit 20 sur la valeur de la dérive de la fréquence porteuse du signal d'horloge fourni au circuit 20. Une troisième courbe 69 correspond à la somme des première et deuxième courbes. La troisième courbe 69 est par conséquent représentative de la dérive totale et effective de la fréquence porteuse du signal d'horloge fourni au circuit 20.

Pendant la première phase P1, c'est-à-dire entre les instants t3 et t4, la valeur de la courbe 67 est égale à zéro. Par conséquent, la courbe 69 suit les variations de la courbe 65. Ainsi, la fréquence diminue pendant la première phase.

Pendant la première phase, comme cela a été mentionné en relation avec la figure 9, l'amplificateur de puissance est désactivé. Par conséquent, le signal de commande EN1 a la deuxième valeur. Puisque le circuit 20 est un émetteur-récepteur RF, l'émetteur-récepteur n'envoie pas de signaux ni en reçoit pendant la première phase.

Au début de la deuxième phase P2, en d'autres termes après l'instant t4, l'élément chauffant a été stoppé. Dans cet exemple, la dérive a atteint zéro, et la fréquence est stabilisée et, puisque cela peut prendre du temps pour que la température du quartz diminue suffisamment notablement pour impacter la fréquence, la dérive provoquée par le quartz reste sensiblement égale à zéro pendant un court moment, par exemple pendant moins de 0,03 secondes. Dans un autre exemple, pendant cette période, la valeur de la dérive peut être différente de zéro.

En outre, à l'instant t4, l'amplificateur de puissance est encore désactivé.

À un instant t5, l'amplificateur de puissance est activé. La période entre les instants t4 et t5 constitue une première partie P21 de la deuxième phase P2 et le reste de la deuxième phase P2 constitue la deuxième partie P22. En variante, la première partie P21 peut être retirée. Dans cette variante, les instants t4 et t5 sont simultanés.

Après l'instant t5, la dérive provoquée par la diminution de la température du quartz (courbe 65) et la dérive provoquée par le circuit 20 (courbe 67) augmentent en valeur absolue. Toutefois, en valeur relative, les valeurs de la dérive provoquée par la diminution de la température du quartz sont positives et augmentent, alors que les valeurs de la dérive provoquée par le circuit 20 sont négatives et diminuent. Par conséquent, ces deux composantes de la dérive totale tendent à se compenser entre elles. En effet, la variation de la dérive totale (courbe 69) est moins importante que la variation de chacune des deux composantes. Les valeurs de la dérive totale sont plus proches de zéro que les valeurs de l'une ou l'autre des deux composantes de dérive.

Le mode de réalisation de la figure 8 tire avantage de cette compensation afin de réduire la dérive en fréquence due au démarrage de l'amplificateur de puissance (courbe 67).

Dans l'exemple de la figure 10, la courbe 69 varie, pendant la deuxième partie P22, entre approximativement -1,3 Hz et approximativement 1 Hz, alors que les valeurs de la courbe 67 sont comprises approximativement entre 0 Hz et -4 Hz. Les valeurs de la courbe 69 sont dans les limites des paramètres acceptables, qui sont une dérive ayant une valeur absolue inférieure à 1,4 Hz, pour une fréquence porteuse souhaitée de 32 MHz, dans la première seconde de fonctionnement du circuit 20.

La durée de la première phase P1, en d'autres termes la différence entre les instants t3 et t4, est de préférence choisie de telle sorte que la dérive provoquée par l'élément chauffant atteigne zéro avant l'instant t4. La durée de la première partie P21 de la deuxième phase est de préférence choisie de manière à optimiser la compensation des dérives. En effet, la diminution de la dérive représentée par la courbe 67 commence peu après l'instant t5, alors que la dérive représentée par la courbe 65 peut, en fonction de la température de l'élément chauffant, prendre un peu de temps avant de commencer à augmenter. Par conséquent, il peut occasionnellement être utile de retarder l'instant t5 par rapport à l'instant t4.

Les caractéristiques de l'élément chauffant, par exemple la valeur de la résistance, la température atteinte et la durée de la première phase, ainsi que la durée de la partie P21, peuvent être choisies en fonction de l'application, afin d'optimiser la compensation. En particulier, la température de l'élément chauffant et la durée de chauffe peuvent dépendre de multiples facteurs, par exemple dépendre des dimensions du dispositif.

Selon un mode de réalisation, la durée entre les instants t2 et t3 est choisie en fonction de la température mesurée par un capteur de température.

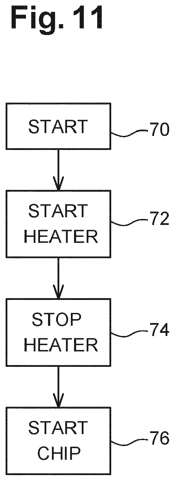

La figure 11 représente un mode de réalisation d'un procédé de commande du dispositif de la figure 8.

Au début du procédé, (bloc 70, START), le quartz et l'oscillateur sont déjà en fonctionnement et fournissent déjà un signal d'horloge au circuit 20. Toutefois, l'amplificateur de puissance du circuit 20 est désactivé.

L'élément chauffant 62 est démarré (bloc 72, START HEATER) par le circuit de commande 32. Cela correspond à l'instant t3. Par exemple, le signal de commande EN3 prend la première valeur. Comme cela a été mentionné précédemment, les caractéristiques de l'élément chauffant et la température atteinte dépendent de l'application. Cela correspond à une étape de chauffage.

À ce stade, la dérive provoquée par le chauffage de l'élément chauffant, à la fois par l'élément chauffant et par son fonctionnement, est la cause principale de la dérive de la fréquence porteuse du signal d'horloge fourni par le circuit oscillant.

Après une durée de chauffage, le circuit de commande cesse de chauffer l'élément chauffant (bloc 74, STOP HEATER). Cela correspond à l'instant t4. Par exemple, le signal de commande EN3 prend la deuxième valeur. L'élément chauffant et le quartz commencent à refroidir. La dérive de fréquence arrête de diminuer.

Après l'étape représentée par le bloc 74, l'élément chauffant n'est de préférence pas utilisé. De préférence, l'élément chauffant n'est pas utilisé en dehors du chauffage du quartz pendant l'étape représentée par le bloc 72, et en particulier pas pendant le fonctionnement du circuit 20.

Ensuite, l'émission de signaux peut être démarrée (bloc 76, START CHIP). Cela correspond à l'instant t5.

Un avantage du mode de réalisation décrit est que, pendant la première seconde du fonctionnement de l'émetteur-récepteur 20, la dérive de la fréquence porteuse est compensée et reste dans les limites des paramètres souhaités.

Un autre avantage du mode de réalisation décrit est qu'il est mis en œuvre avec peu de modifications et peu de composants.

Divers modes de réalisation et variantes ont été décrits. La personne du métier comprendra que certaines caractéristiques de ces divers modes de réalisation et variantes pourraient être combinées, et d'autres variantes apparaitront à la personne du métier. En particulier, alors que le mode de réalisation des figures 6 et 7 et le mode de réalisation des figures 8 à 11 ont été décrits en relation avec un dispositif semi-duplex, ils peuvent facilement être adaptés pour être mis en œuvre sur des dispositifs en duplex intégral. Par exemple, un dispositif en duplex intégral peut comprendre un commutateur, ou un relais MARCHE/ARRET, entre la sortie TX et l'antenne, autorisant ou bloquant le passage de signaux allant de la sortie TX vers l'antenne. Ce commutateur serait contrôlé par le signal EN2 comme cela a été décrit dans la présente description pour le commutateur 29.

En outre, les différents modes de réalisation décrits peuvent être mis en œuvre tous ensemble ou deux par deux. Par exemple, le mode de réalisation des figures 1 à 5 et le mode de réalisation des figures 8 à 11 peuvent être mis en œuvre conjointement. Dans ce cas, l'amplificateur de puissance est activé à l'instant t5 de la figure 10, et le passage du signal entre la sortie TX et l'antenne est activé plus tard que l'instant t5, après le retard D.

Enfin, la mise en œuvre pratique des modes de réalisation et variantes décrits est à la portée de la personne du métier à partir des indications fonctionnelles données ci-dessus.

**Revendications**

1. Dispositif (60) comprenant :

   - un circuit électronique (20) ;
   - un circuit oscillant (12) comprenant un quartz (14), configuré pour fournir un signal d'horloge au circuit électronique (20) ; et
   - un élément chauffant (62) configuré pour augmenter la température du quartz (14).

2. Dispositif selon la revendication 1, comprenant une antenne (22), dans lequel le circuit électronique (20) est un émetteur-récepteur radiofréquence et est couplé à l'antenne (22) .

3. Dispositif selon la revendication 1 ou 2, comprenant un circuit de commande (28) configuré pour contrôler l'élément chauffant (62).

4. Dispositif selon l'une quelconque des revendications 1 à 3, dans lequel l'élément chauffant (62) est dédié au chauffage du quartz (14).

5. Dispositif selon l'une quelconque des revendications 1 à 4, dans lequel l'élément chauffant (62) est éloigné du quartz (14) de moins de 10 mm.

6. Dispositif selon l'une quelconque des revendications 1 à 5, dans lequel l'élément chauffant (62) est une résistance.

7. Dispositif selon l'une quelconque des revendications 1 à 6, comprenant :

   une antenne (22) ;
   un circuit de commande (32) configuré pour activer un amplificateur de puissance (21) du circuit (20) et pour activer le passage de signaux à émettre du circuit (20) vers l'antenne, l'activation du passage du signal du circuit (20) vers l'antenne (22) étant retardée par rapport à un instant à partir duquel l'amplificateur de puissance (21) est activé.

8. Dispositif selon l'une quelconque des revendications 1 à 7, comprenant, couplés en série, un premier condensateur variable (38), un premier condensateur (42), le cristal de quartz (14) et un deuxième condensateur variable (40).

9. Procédé de commande d'un dispositif selon les revendications 1 à 8, comprenant les étapes suivantes :

- A) chauffer le quartz (14) ;
- B) activer l'émission de signaux à émettre lorsque la température du quartz diminue.

10. Procédé selon la revendication 9 dans son rattachement à la revendication 6, dans lequel l'étape A) comprend l'augmentation d'un courant passant dans la résistance.

11. Procédé selon la revendication 9 ou 10 dans son rattachement à la revendication 7, dans lequel l'activation du passage du signal du circuit (20) vers l'antenne est retardée par rapport à un instant à partir duquel un amplificateur de puissance du circuit (20) est activé.

12. Procédé selon l'une quelconque des revendications 9 à 11 dans son rattachement à la revendication 8, comprenant un contrôle des capacités des premier et deuxième condensateurs variables (38, 40) pour qu'elles soient supérieures à 50 % de leur capacité maximum.

# Fig. 1

# Fig. 2

# Fig. 3

# Fig. 4

# Fig. 5

```
┌──────────────┐
│    START     │────60
└──────────────┘
        │
        ▼
┌──────────────┐
│   MEA T°     │────62
└──────────────┘
        │
        ▼
┌──────────────┐
│    DET D     │────64
└──────────────┘
        │
        ▼
┌──────────────┐  ────66
│    EN1       │─ ─ ─ ─ ─ ─ ─ ─┐
└──────────────┘               │
        │                      │ D
        ▼                      │
┌──────────────┐               ▼
│    EN2       │─ ─ ─ ─ ─ ─ ─ ─┘
└──────────────┘  ────68
        │
        ▼
┌──────────────┐
│     EM       │────70
└──────────────┘
        │
        ▼
┌──────────────┐
│    END       │────72
└──────────────┘
```

## Fig. 6

## Fig. 7

# Fig. 8

EP 3 869 692 A1

# Fig. 9

# Fig. 10

# Fig. 11

```
+-------------+
|   START     |----70
+-------------+
       |
       v
+-------------+
|   START     |----72
|   HEATER    |
+-------------+
       |
       v
+-------------+
|   STOP      |----74
|   HEATER    |
+-------------+
       |
       v
+-------------+
|   START     |----76
|   CHIP      |
+-------------+
```

**Europäisches Patentamt**

**European Patent Office**

**Office européen des brevets**

# RAPPORT DE RECHERCHE EUROPEENNE

Numéro de la demande

EP 21 15 6696

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2016/277031 A1 (YONEZAWA TAKEMI [JP] ET AL) 22 septembre 2016 (2016-09-22) <br> * alinéa [0043] - alinéa [0065]; figures 1-3 * <br> * alinéa [0102] - alinéa [0114]; figures 16,17 * <br> ----- | 1-12 | INV. <br> H03L1/02 <br> H04B1/48 |
| Y | FR 3 074 624 A1 (ST MICROELECTRONICS GRENOBLE 2 [FR]; ST MICROELECTRONICS ALPS SAS [FR]) 7 juin 2019 (2019-06-07) <br> * page 5, ligne 10 - ligne 20 * <br> * page 7, ligne 6 - ligne 14; figure 1 * <br> * page 7, ligne 20 - page 11, ligne 8; figures 2,3 * <br> ----- | 1-12 | |
| Y | US 2003/197567 A1 (VILLELLA DAVID A [US]) 23 octobre 2003 (2003-10-23) <br> * alinéa [0003] * <br> * alinéa [0015] - alinéa [0034]; figure 1 * <br> ----- | 1-12 | |
| A | US 6 362 700 B1 (FRY STEVEN J [US]) 26 mars 2002 (2002-03-26) <br> * colonne 3, ligne 33 - colonne 4, ligne 39; figure 1 * <br> ----- | 1-12 | **DOMAINES TECHNIQUES RECHERCHES (IPC)** <br> H03L <br> H04B |
| A | WO 94/11763 A1 (WESTERN ATLAS INT INC [US]) 26 mai 1994 (1994-05-26) <br> * page 4, ligne 16 - page 5, ligne 19; figures 1,3 * <br> ----- | 1-12 | |

Le présent rapport a été établi pour toutes les revendications

| Lieu de la recherche | Date d'achèvement de la recherche | Examinateur |
|---|---|---|
| La Haye | 29 juin 2021 | Aouichi, Mohamed |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 21 15 6696

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-06-2021

| Document brevet cité<br>au rapport de recherche | Date de<br>publication | Membre(s) de la<br>famille de brevet(s) | Date de<br>publication |
|---|---|---|---|
| US 2016277031 A1 | 22-09-2016 | CN 105991128 A<br>JP 6572571 B2<br>JP 2016174210 A<br>US 2016277031 A1 | 05-10-2016<br>11-09-2019<br>29-09-2016<br>22-09-2016 |
| FR 3074624 A1 | 07-06-2019 | CN 110048713 A<br>CN 209313796 U<br>FR 3074624 A1<br>US 2019173427 A1 | 23-07-2019<br>27-08-2019<br>07-06-2019<br>06-06-2019 |
| US 2003197567 A1 | 23-10-2003 | AUCUN | |
| US 6362700 B1 | 26-03-2002 | US 6362700 B1<br>WO 0227915 A1 | 26-03-2002<br>04-04-2002 |
| WO 9411763 A1 | 26-05-1994 | CA 2127809 A1<br>EP 0635137 A1<br>WO 9411763 A1 | 26-05-1994<br>25-01-1995<br>26-05-1994 |

EPO FORM P0460

Pour tout renseignement concernant cette annexe : voir Journal Officiel de l'Office européen des brevets, No.12/82